# EUROPEAN PATENT APPLICATION

(11) **EP 1 093 233 A1**
(43) Date of publication of application: **18.04.2001**
(21) Application number: 00919166.9
(22) Date of filing: 25.04.2000
(51) Int. Cl.: H04B 1/04, H03G 3/02

(54) **APPARATUS AND METHOD FOR POWER CONTROL**

(30) Priority: 27.04.1999 JP 11959499
(71) Applicant: MATSUSHITA ELECTRIC INDUSTRIAL CO., LTD., Kadoma-shi, Osaka 571-8501 (JP)
(72) Inventor: KINOMURA, Masahiro, Hamamatsu-shi, Shizuoka 435-0031 (JP); OBARA, Toshio, Kawasaki-shi, Kanagawa 212-0025 (JP)
(74) Representative: Grünecker, Kinkeldey, Stockmair & Schwanhäusser Anwaltssozietät
(86) International application number: JP0002682
(87) International publication number: WO0065728

(57) **Abstract**

A gate voltage storage table 103 stores therein a control voltage at the time of an inverse gain characteristic of a power amplifier of signals. The control voltage is read from the gate voltage storage table 103 in response to a linear control signal. An average between a gain characteristic of the power amplifier 101 and the inverse gain characteristic thereof is taken in such a manner that this read control voltage is applied to a control electrode of the power amplifier 101, thus gain of the power amplifier 101 becomes linear.

## Description

### Technical Field

The present invention relates to a power control apparatus and a method of the same in which a power amplifier is employed for a mobile station apparatus or a base station apparatus or so forth of a mobile communication system depending on CDMA (Code Division Multiple Access) system. The power control apparatus and the method of the same of the present invention are appropriate for designing proper control of power gain, miniaturization of a circuit and realization of low power consumption in such a manner as to control a gain control voltage (gate voltage) of the power amplifier.

### Background Art

Conventionally, such a power control apparatus and a method of the same are described in an official gazette of the Japanese Patent Application Laid-Open No. HEI 7-336243. FIG. 1 is a block diagram illustrating a configuration of a conventional power control apparatus for transmission.

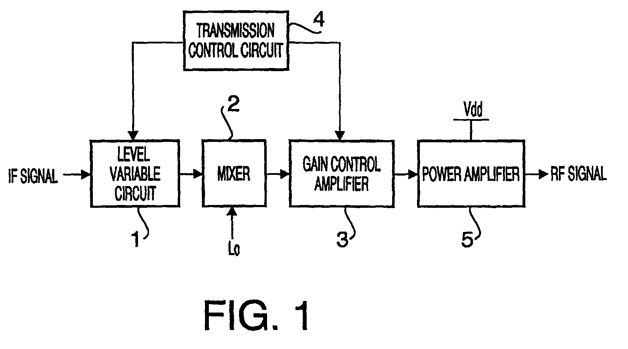

The power control apparatus illustrated in this FIG. 1 is configured to be provided with a level variable circuit 1 of IF (Intermediate Frequency) stage, a mixer 2 for converting IF signals into RF (Radio Frequency) signals, a gain control amplifier 3 of the RF stage, a transmission control circuit 4 and a power amplifier 5.

In such a configuration, a level of the IF signals is controlled into a predetermined level in response to control of the transmission control circuit 4 in the level variable circuit 1. The IF signals which are set to the predetermined level are converted into the RF signals of a radio frequency in such a manner as to be mixed with a local oscillation signal "Lo" by means of the mixer 2, followed by being outputted to the gain control amplifier 3.

In this gain control amplifier 3, the RF signals are amplified with predetermined gain depending on control of the transmission control circuit 4, further these amplified RF signals are subjected to fixed power amplification in the power amplifier 5, before being transmitted.

Thus, it is the level variable circuit 1 and the gain control amplifier 3 that implement control for transmission power. In the power amplifier 5, amplification with specific gain is performed. Further, a control range per one stage of the level variable circuit 1 and the gain control amplifier 3 is the degree of 20 to 30 dB.

However, in the conventional apparatus, a dynamic range of transmission level control is as broad as the degree of 70 dB. Moreover, the maximum transmission mean power differs according to transmission rates and so forth. Therefore, when the conventional apparatus is employed as transmission circuits such as the CDMA system and so forth in which transmission power should be switched, it becomes necessary to provide level variable circuits such as a variable attenuator or a variable amplifier or so forth in order to insure a dynamic range of the transmission level control.

Further, in a conventional circuit configuration, since control quantity per one stage is the degree of 20 to 30 dB, it is difficult to satisfy the dynamic range of a wide range by only one stage of the level variable circuit. Thus, these circuits should be provided at the IF stage, the RF stage or both stages as multiple stages.

For that reason, there is a problem that a scale of the power amplifier is increased, thus resulting in an increase of power consumption with the scale of the circuit increased.

Further, even though when an output signal level is low or signal is not inputted yet, an idle current flows. Thus there is a problem that efficiency under low output level is degraded remarkably with width of the dynamic range increasing.

### Disclosure of Invention

An object of the present invention is to provide a power control apparatus and method of the same in which it is possible to realize miniaturization of a scale of a power amplifier, a decrease of power consumption and improvement of efficiency when signal is not inputted yet or an output signal level is low.

The subject matter of the present invention is that a power control apparatus and a method of the same cause storage means to store therein a control voltage at the time of an inverse gain characteristic of an amplifier of signals, subsequently, reading out the control voltage from the storage means in response to a linear control signal. Next, an average between a gain characteristic of the amplifier and an inverse gain characteristic thereof is taken in such a manner as to apply this read control voltage to a control electrode of the amplifier, thus gain of the amplifier is made liner.

### Brief Description of Drawings

FIG. 1 is a block diagram illustrating a configuration of a conventional power control apparatus for transmission;
FIG. 2A is a block diagram illustrating a configuration of a power control apparatus according to an embodiment 1 of the present invention;
FIG. 2B is a graph illustrating a relationship between a control signal voltage and control quantity;
FIG. 2C is a graph illustrating a relationship between gain of a power amplifier and a gate voltage;
FIG. 2D is a graph illustrating a relationship between gain of a power amplifier and a control signal voltage;
FIG. 3 is a characteristic view for explaining operation of power control in the power control apparatus according to the embodiment 1;
FIG. 4 is an another characteristic view for explaining operation of power control in the power control apparatus according to the embodiment 1;
FIG. 5 is a block diagram illustrating a configuration of a power control apparatus according to an embodiment 2 of the present invention;
FIG. 6 is a relationship view between gain and output power of the power amplifier in the power control apparatus according to the embodiment 2;
FIG. 7 is a flowchart for explaining operation of power control in the power control apparatus according to the embodiment 2;
FIG. 8 is a block diagram illustrating a configuration of a transmission apparatus according to an embodiment 3 of the present invention;
FIG. 9 is a block diagram illustrating a configuration of a radio apparatus according to an embodiment 4 of the present invention; and
FIG. 10 is a block diagram illustrating a configuration of a mobile communication system according to an embodiment 5 of the present invention.

### Best Mode for Carrying out the Invention

Embodiments of the present invention will be described specifically below with reference to accompanying drawings.

### (Embodiment 1)

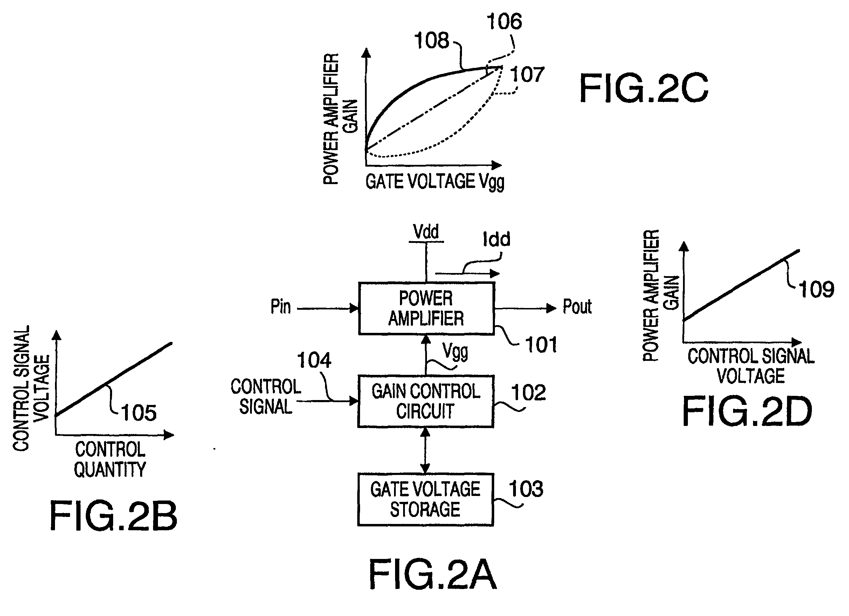

FIG. 2A is a block diagram illustrating a configuration of a power control apparatus according to an embodiment 1 of the present invention. The power control apparatus illustrated in FIG. 2A is configured to be provided with a power amplifier 101, a gain control circuit 102 and a gate voltage storage table 103.

The power amplifier 101 amplifies power of an input signal (for instance RF signal) "P-in", followed by outputting this amplified signal "P-out". The gain control circuit 102 reads out a gate voltage (gain control voltage) "Vgg" from the gate voltage storage table 103 in response to a control signal 104, followed by controlling gain of the power amplifier 101 depending on this read gate voltage "Vgg".

Further, a specific characteristic of the control signal 104 is that, in FIG. 2B, as illustrated in a straight line 105 of a characteristic of control signal, the voltage rises linearly with specific inclination in proportion to control quantity.

The gate voltage "Vgg" stored in the gate voltage storage table 103 is to perform control for permitting the gain of the power amplifier 101 to be linear as illustrated in the straight line 106. Namely, an average between a gain characteristic 107 of the power amplifier 101 in FIG. 2C and an inverse gain characteristic 108 thereof is taken to obtain linear gain 106. The gain of the power amplifier 101 is controlled by the use of the gate voltage "Vgg" with linear gain 106 so that it is possible to render the gain of the power amplifier 101 linear. In other words, it is possible to render the gain of the power amplifier 101 linear such as a straight line 109 as illustrated in FIG. 2D due to a linear control signal voltage 105.

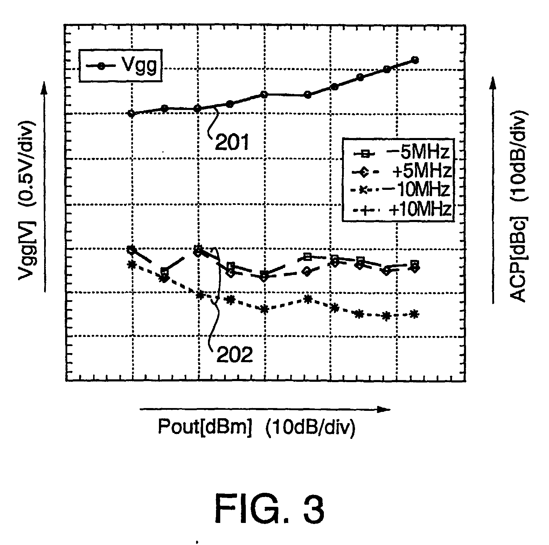

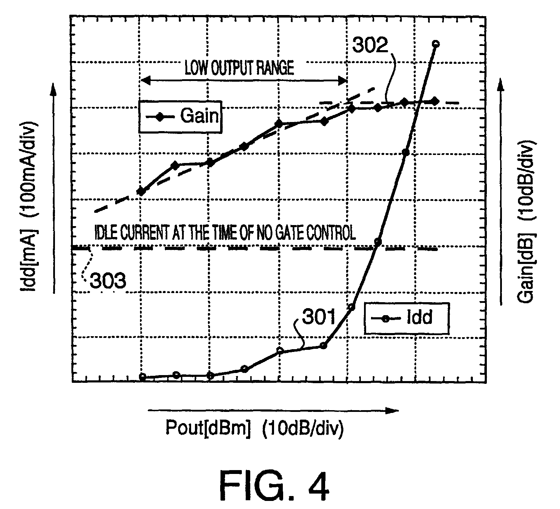

Further, a specific characteristic of the power amplifier 101 employed for power control in the embodiment 1 is illustrated in FIG. 3 and FIG. 4. FIG. 3 is a view illustrating a distortion characteristic of the power amplifier 101, in which the gate voltage "Vgg" illustrated by the use of 201 and adjacent channel leakage power (ACP = distortion characteristic) illustrated by the use of 202 are measured under the condition of roughly the same ACP against the output power "P-out" of the power amplifier 101 to which both of the power supply voltage "Vdd" and the gate voltage "Vgg" are applied.

According to this FIG. 3, when the output power "P-out" is lowered progressively under specific distortion quantity, the characteristic of the gate voltage "Vgg" gradually becomes low.

Further, FIG. 4 is a characteristic view in the case where current consumption "Idd" illustrated by the use of 301 and gain illustrated by the use of 302 are measured under the condition of roughly the same ACP against the output power "P-out" of the power amplifier 101 to which both of the power supply voltage "Vdd" and the gate voltage "Vgg" are applied in the same way as the configuration of FIG. 2. Furthermore, the characteristic against the respective output power "P-out" corresponds to that of the gate voltage "Vgg" in FIG. 2.

According to FIG. 4, when the output power "P-out" is lowered progressively under the condition of fixed distortion quantity, the characteristic of the Gain 302 gradually lowers with rough constant rate in a low output range. Further, the characteristic of the current consumption "Idd" 301 lowers sharply. Consequently, when the gate voltage control is performed, the current is capable of being reduced largely in comparison with the idle current 303 under the condition that the gate voltage control is not performed.

According to the above matter, it is possible to perform control of gain and a decrease of a current without deteriorating a distortion characteristic by controlling a gate voltage under the condition of the specific distortion characteristic.

Thus, according to the power control apparatus of the embodiment, even though the power amplifier 101 has not a linear characteristic against the gate voltage "Vgg" in connection with its gain, it becomes possible to employ the power amplifier 101 as a linear level variable circuit (variable amplifier or variable attenuator) on its inside of the low output range. What is described is capable of being performed in such a manner that the gate voltage "Vgg" is set such a value that the gain of the power amplifier 101 becomes linear against the linear control signal 104. In addition thereto, it becomes possible to cut current consumption and an idle current.

### (Embodiment 2)

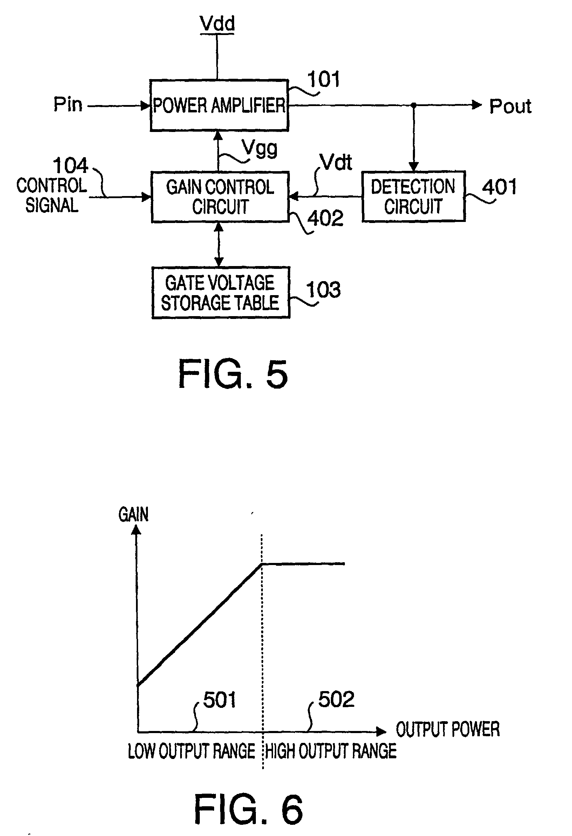

FIG. 5 is a block diagram illustrating a configuration of a power control apparatus according to an embodiment 2 of the present invention. However, in the embodiment 2 illustrated in FIG. 5, the same signs are added to corresponding parts to respective parts of the embodiment 1 of FIG. 2 to omit an explanation thereof.

There are differences between the power control apparatus of embodiment 2 illustrated in FIG. 5 and that of embodiment 1 in that the apparatus of the embodiment 2 is configured to implement detection of a voltage of the output signal "P-out" by the use of its detection circuit 401, followed by outputting this detection voltage "Vdt" to a gain control circuit 402. The gain control circuit 402 implements operation of gain control described in the embodiment 1 in cases where the gain control circuit 402 possesses the same function as the gain control circuit 102 described in the embodiment 1 and further a supplied detection voltage "Vdt" is a voltage value which falls in a low output range 501 illustrated in FIG. 6. While when the supplied detection voltage "Vdt" is a voltage value which falls in a high output range 502, the gain control circuit 402 halts on its operation of the gain control.

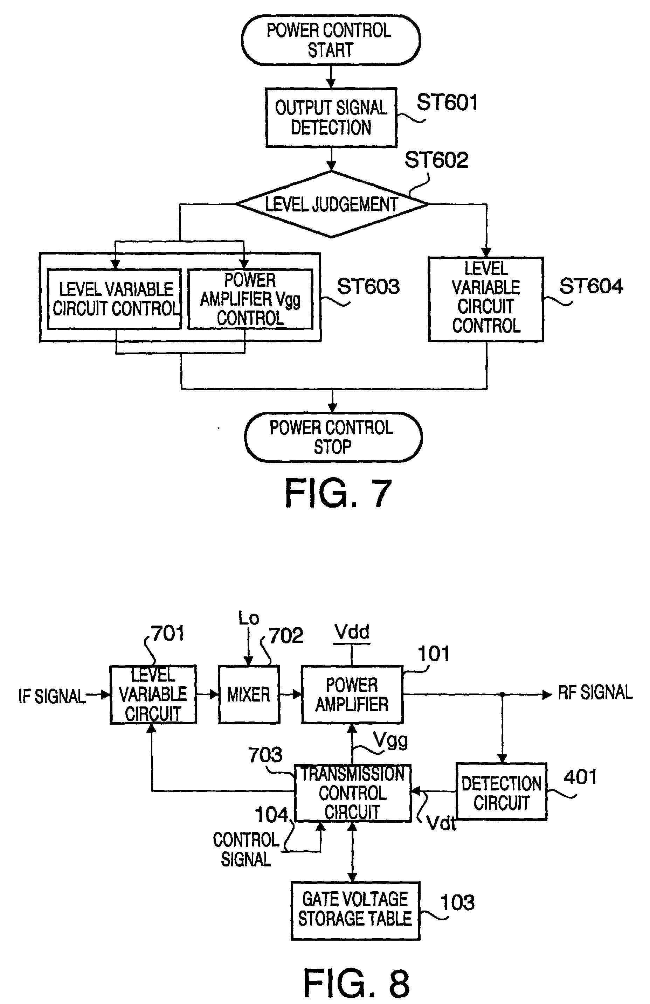

Operation of the power control apparatus in such a configuration will be described referring to a flowchart of FIG. 7.

In step ST601, the detection circuit 401 performs detection of a voltage of the output signal "P-out", followed by outputting this detection voltage "Vdt" to the gain control circuit 402.

In step ST602, the gain control circuit 402 determines whether the level of the detection voltage "Vdt" falls in the low output range 501 or falls in the high output range 502.

In step ST603, when a result of the determination is that the level of the detection voltage "Vdt" falls in the low output range 501 in step 602, the gain control circuit 402 performs set-voltage control of a linear level variable circuit in response to the control signal 104 and the gain control circuit 402 controls a gate voltage of the power amplifier 101 on the basis of the gate voltage storage table 103 to lower the gain.

In step ST604, when a result of the determination is that the level of the detection voltage "Vdt" falls in the high output range 502 in step 602, the power amplifier 101 is not controlled on its gate voltage "Vgg", but operates as the power amplifier 101 with specific gain. Only the level variable circuit performs the level control.

Thus, according to the power control apparatus of the embodiment 2, the gate voltage "Vgg" of the power amplifier 101 is set by the gain control circuit 402 in response to the linear control signal 104. Further, the gain control circuit 402 sets the gate voltage "Vgg" by reading out from the gate voltage storage table 103. Furthermore, the detection of the output signal "P-out" is performed by the detection circuit 401. Then, the detection voltage "Vdt" is informed to the gain control circuit 402. Thus, gate voltage control is not performed at the time of high output in that the gain takes fixed value although control of the gate voltage "Vgg" is performed. Thus, the apparatus permits the power amplifier 101 to operate as a general power amplifier 101 with the specific gain.

For that reason, it becomes possible to employ one power amplifier 101 as two kinds of circuits in that the power amplifier 101 is employed as the level variable circuit in a low level output range, while the power amplifier 101 is employed as the power amplifier with specific gain in a high level output range.

Moreover, as described in the embodiment 1, since the power amplifier 101 is employed in the state of low current consumption compared to the idle current "Idd" when control of the gate voltage "Vgg" is not performed, it becomes possible to perform the control in the best efficient state.

### (Embodiment 3)

FIG. 8 is a block diagram illustrating a configuration of a transmission apparatus according to an embodiment 3 of the present invention. However, in the embodiment 3 illustrated in this FIG. 8, the same signs are added to corresponding parts to respective parts of the embodiment 2 of FIG. 5 to omit an explanation thereof.

The transmission apparatus of the embodiment 3 illustrated in FIG. 8 is provided with a level variable circuit 701 which causes a level of the IF signal to be varied, a mixer 702 for converting the IF signals into the RF frequency in such a manner as to mix the IF signals with the local oscillation signal "Lo", in addition to the configuration elements of the power control apparatus illustrated in FIG. 5, and a transmission control circuit 703 possesses a function for controlling the level variable circuit 701 in addition to the function of the gain control circuit 402 illustrated in FIG. 5.

In such a configuration, when a detection voltage "Vdt" of the detection circuit 401 is determined that the detection voltage "Vdt" falls in the range of low output transmission in the transmission control circuit 703, the transmission control circuit 703 controls the power amplifier 101 in connection with its gate voltage "Vgg" to lower the gain by the use of the control signal 104, while when a detection voltage "Vdt" is determined that the voltage "Vdt" falls in the range of high output transmission, the transmission control circuit 703 does not control the power amplifier 101 in connection with its gate voltage "Vgg", but permits the power amplifier 101 to be operated as a power amplifier with specific gain.

In this manner, according to the transmission apparatus of the embodiment 3, even though in the case where a high dynamic range is required, it becomes not necessary to increase the level variable circuit 701 in connection with its stage into the state of multiple stages such as a conventional one.

Up to the present, in cases where the dynamic range of the transmission level control becomes as wide as a degree of 70 dB such as the CDMA system, since the dynamic range per 1 (one) stage of the level variable circuit is as narrow as a degree of 20 dB, it was necessary to insert the level variable circuit of 1 (one) to 2 (two) stages into respective the IF stage and the RF stage. However, in the embodiment 3, the power amplifier 101 is capable of being employed, like the level variable circuit (variable amplifier or variable attenuator), by controlling the gate voltage. Thus, it is possible to delete the level variable circuit of the RF stage, which was necessary to be provided for the conventional apparatus up to the present.

For that reason, it becomes to possible to cut power consumption corresponding to that of the deleted level variable circuit.

### (Embodiment 4)

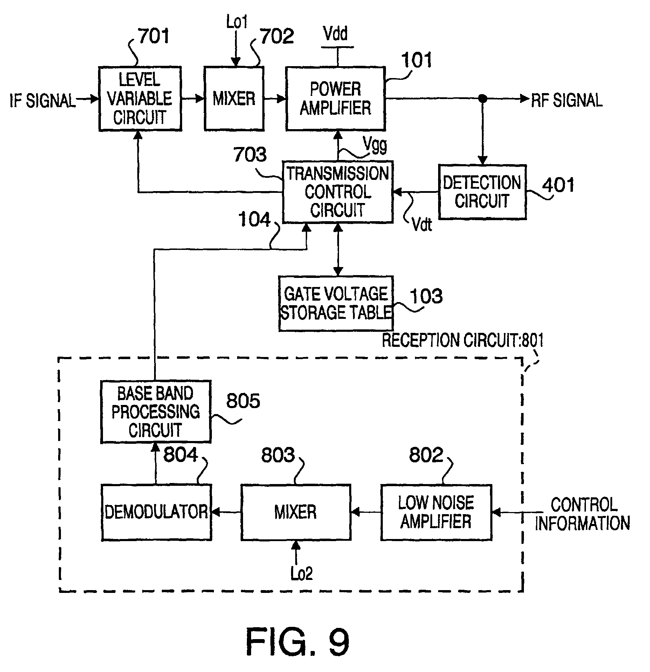

FIG. 9 is a block diagram illustrating a configuration of a radio apparatus according to an embodiment 4 of the present invention. However, in the embodiment 4 illustrated in this FIG. 9, the same signs are added to corresponding parts to respective parts of the embodiment 3 of FIG. 8.

The radio apparatus illustrated in FIG. 9 is configured to be provided with a reception circuit 801 in addition to the transmission apparatus of the embodiment 3 illustrated in FIG. 8. The reception circuit 801 is configured to be provided with a low noise amplifier 802, a mixer 803, a demodulator 804, and a base band processing circuit 805.

In such a configuration, the low noise amplifier 802 amplifies received control information indicating instructions of a transmission level from a partner's radio apparatus which is not illustrated. The mixer 803 converts the amplified signals into IF signals while mixing this amplified signals with local oscillation signals "Lo2". The demodulator 804 demodulates this IF signals, subsequently, the base band processing circuit 805 implements base band processing to convert it into the control signal 104 that is described above, thus the control signal 104 is outputted to the transmission control circuit 703.

In this case, since the control signal 104 indicates instructions of the transmission level from the radio apparatus of the partner to the radio apparatus of this side, the transmission control circuit 703 reads out the gate voltage "Vgg" from the gate voltage storage table 103 in response to the control signal 104, followed by controlling the gain of the power amplifier 101, thus transmission RF signals are amplified to a transmission level instructed by the partner by controlling the gain of the power amplifier 101.

In this manner, according to the radio apparatus of the embodiment 4, since the transmission control circuit 703 controls the power amplifier 101 on the basis of transmission level control information processed by the base band processing circuit 805 of the reception circuit 801, it is possible to control the transmission level automatically in response to the control information transmitted from the radio apparatus of the partner.

### (Embodiment 5)

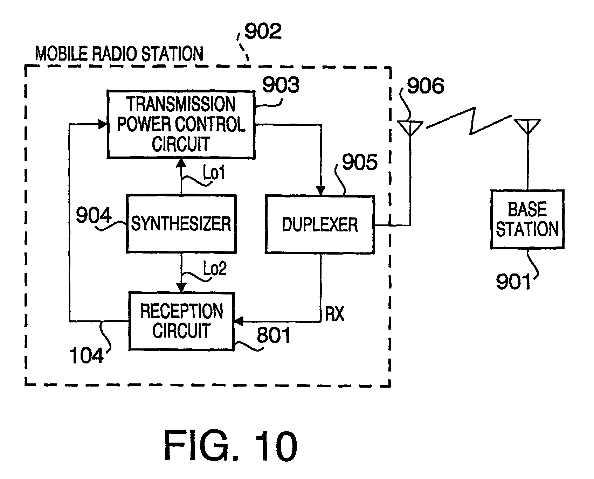

FIG. 10 is a block diagram illustrating a configuration of a mobile communication system according to an embodiment 5 of the present invention. However, in the embodiment 5 illustrated in FIG. 10, the same signs are added to corresponding parts to respective parts of the embodiment 4 of FIG. 9 to omit an explanation thereof.

The mobile communication system illustrated in FIG. 10 is configured to be provided with a base station 901 and a mobile station 902. The mobile station 902 is configured to be provided with the reception circuit 801 described in FIG. 9, a transmission power control circuit 903, a synthesizer 904, a duplexer 905, and an antenna 906.

Further, the transmission power control circuit 903 is configured to be provided with the level variable circuit 701, the mixer 701, the power amplifier 101, the detection circuit 401, the gate voltage storage table 103, and the transmission control circuit 703, all of which are illustrated in FIG. 9.

The synthesizer 904 oscillates local oscillation signals "Lo1" and "Lo2" that are outputted to the mixer 702 and the mixer 803.

The duplexer 905 outputs a transmission signal "Tx" outputted from the transmission power control circuit 903 to the antenna 906 and outputs a reception signal "Rx" from the base station 901 received through the antenna 906 to the reception circuit 801.

The base station 901 transmits various kinds of control information that are determined on the occasion of commencement of communication between the base station 901 and the mobile station 902, and control information indicating instructions of the transmission level to the mobile station 902.

In such a configuration, when the reception circuit 801 of the mobile station 902 receives the control information indicating instructions of the transmission level from the base station 901, the reception circuit 801 amplifies the reception signal, followed by converting the reception signal into the IF signal while mixing the IF signal with the local oscillation signal "Lo2", before demodulating the IF signal. Subsequently, the reception circuit 801 performs base band processing to the demodulated IF signal to convert it into the control signal 104 that is described above, followed by outputting it to the transmission control circuit 903.

In this case, in the transmission power control circuit 903, since the control signal 104 indicates instructions of the transmission level to the mobile station 902 from the base station 901, the transmission control circuit 703 reads out the gate voltage "Vgg" from the gate voltage storage table 103 in response to the control signal 104, followed by controlling the gain of the power amplifier 101, thus the transmission signal "Tx" is amplified to the transmission level instructed by the partner.

In this manner, according to the mobile communication system of the embodiment 5, although, in the power control of the conventional mobile station, a circuit scale becomes large with progression of a high dynamic range, thus resulting in deterioration of efficiency at the time of low output transmission, however in power control by this transmission power control circuit 903, it is possible to design miniaturization of the circuits. Further, the power control of the transmission power control circuit 903 does not degrade a distortion notwithstanding high dynamic range, thus, it becomes possible to perform such power control in state where current consumption is the best suited.

The power control apparatus of the present invention adopts a configuration provided with an amplifier for amplifying signals, a storage unit for storing control voltage at the time of an inverse gain characteristic of the amplifier, and a controller for reading out the control voltage from the storage unit in response to a linear control signal, followed by applying this read control voltage to a control electrode of the amplifier.

According to this configuration, a gain characteristic of the amplifier and an inverse gain characteristic thereof are averaged in such a manner that the control voltage is applied to the control electrode. Thus, it enables the gain of the amplifier to be linear. Consequently, even though the gain characteristic of the amplifier is not originally linear, it becomes possible to employ the amplifier in connection with its low output range as a linear level variable circuit (variable amplifier or variable attenuator). For that reason, it becomes possible to cut the current consumption and the idle current.

The power control apparatus of the present invention, in the above-described configuration, adopts a configuration in which the control voltage corresponds to a gate voltage of a field-effect transistor when the amplifier is the field effect transistor. According to this configuration, although if the amplifier is the field-effect transistor, it is possible to obtain the same operation and an effect as that of the first aspect described-above.

The power control apparatus of the present invention, in the above-described configuration, adopts a configuration in which there is provided a detector for performing detection of an output voltage of the amplifier, followed by outputting this detection voltage to the control unit, then, the control unit adjusts the amplifier in connection with its output power quantity so as to satisfy a distortion characteristic of this amplifier if the detection voltage falls in the range where the gain of the amplifier is saturated fixedly.

According to this configuration, it becomes possible to employ the amplifier as two kinds of circuits in which the amplifier is employed as a level variable circuit in a low level output range, while the amplifier is employed as an amplifier with specific gain in a high level output range.

The power control apparatus of the present invention adopts a configuration provided with a level variable unit which permits a level of an intermediate frequency signal to be varied, a mixer for converting the intermediate frequency signal from the level variable unit into a radio frequency signal, an amplifier for amplifying the radio frequency signal, a storage unit for storing therein a control voltage at the time of an inverse gain characteristic of the amplifier, and a control unit for reading out the control voltage from the storage unit in response to a linear control signal, followed by applying the read control voltage to the level variable unit and a control electrode of the amplifier.

According to this configuration, in the transmission apparatus, like the level variable circuit, it is possible to employ the amplifier in that the gain of the amplifier is controlled linearly. Thus, it is possible to delete the level variable circuit of the RF stage that is required for the apparatus up to the present. For that reason, it becomes possible to realize simplification of the circuit configuration, as well as it is possible to cut power consumption corresponding to that of the deleted level variable circuit.

The power control apparatus of the present invention, in the above-described configuration, adopts a configuration in which the control voltage corresponds to a gate voltage of a field-effect transistor when the amplifier is the field effect transistor. According to this configuration, although if the amplifier is the field-effect transistor, it is possible to obtain the same operation and an effect as that of the fourth aspect described-above.

The power control apparatus of the present invention, in the above-described configuration, adopts a configuration in which there is provided a detector for performing detection of an output voltage of the amplifier, followed by outputting this detection voltage to the control unit, when the detection voltage takes a voltage value which corresponds to a range where the gain of the amplifier is saturated fixedly regardless of control depending on the control voltage, operation of the control unit halts.

According to this configuration, in the amplifier of the transmission apparatus, it becomes possible to employ the amplifier as two kinds of circuits in which the amplifier is employed as a level variable circuit in a low level output range, while the amplifier is employed as an amplifier with specific gain in a high level output range.

The radio apparatus of the present invention adopts a configuration in which the radio apparatus is provided with the transmission apparatus of the above-described configuration and a reception unit of signals, further, the control unit of the transmission apparatus reads out the control voltage from the storage means of the transmission apparatus in response to transmission power control information received by the reception unit instead of the control signal, followed by applying this read control voltage to the level variable unit of the transmission apparatus and the control electrode of the amplifier.

According to this configuration, since the control unit of the radio apparatus controls the gain of the amplifier on the basis of the received transmission level control information, it is possible to control the transmission power automatically in response to the control information transmitted from the radio apparatus of the partner side.

The mobile station apparatus of the present invention adopts a configuration in which the mobile station apparatus is provided with the transmission apparatus of the above-described configuration and a reception unit of signals, further, the control unit of the transmission apparatus reads out the control voltage from the storage means of the transmission apparatus in response to transmission power control information from the base station apparatus received by the reception unit instead of the control signal, followed by applying this read control voltage to the level variable unit of the transmission apparatus and the control electrode of the amplifier.

According to this configuration, since the control unit of the mobile station apparatus controls the gain of the amplifier on the basis of the received transmission level control information from the base station apparatus, it is possible to control the transmission power automatically in response to the control information transmitted from the base station apparatus.

The mobile communication system of the present invention adopts a configuration in which the mobile communication system is provided with the base station apparatus transmitting the transmission power control information the transmission apparatus of the above-described configuration and a reception unit of signals, further, the control unit of the transmission apparatus reads out the control voltage from the storage means of the transmission apparatus in response to transmission power control information received by the reception unit instead of the control signal, furthermore the mobile communication system is provided with a mobile station apparatus which applies the read control voltage to the level variable unit of the transmission apparatus and the control electrode of the amplifier.

According to this configuration, in the mobile communication system, since the mobile station apparatus controls the gain of the amplifier on the basis of the received transmission level control information from the base station apparatus, it is possible to control the transmission power automatically in response to the control information transmitted from the base station apparatus.

The power control method of the present invention permits a storage unit to store therein a control voltage at the time of an inverse gain characteristic of an amplifier of signals, followed by reading out the control voltage from the storage unit in response to a linear control signal, then, applying this read control voltage to the control electrode of the amplifier.

According to this method, a gain characteristic and an inverse gain characteristic of the amplifier are averaged in such a manner that the control voltage is applied to the control electrode. Thus, it enables the gain of the amplifier to be linear. Consequently, even though the gain characteristic of the amplifier is not originally linear, it becomes possible to employ the amplifier in connection with its low output range as a linear level variable circuit (variable amplifier or variable attenuator). For that reason, it becomes possible to cut the current consumption and the idle current.

The power control method of the present invention, in the above-described method, permits detection of an output voltage of the amplifier to be performed, when the detection voltage takes a voltage value which corresponds to a range where the gain of the amplifier is saturated fixedly regardless of control depending on the control voltage, the method permits the control for applying the control voltage to the control electrode to be stopped.

According to this method, it becomes possible to employ the amplifier as two kinds of circuits in which the amplifier is employed as a level variable circuit in a low level output range, while the amplifier is employed as an amplifier with specific gain in a high level output range.

A power control method of the present invention permits a level of intermediate frequency signals to be varied by the use of a level variable unit, subsequently, permitting the intermediate frequency signals with its level varied to be converted into radio frequency signals, next, permitting a storage unit to store therein a control voltage at the time of an inverse gain characteristic of an amplifier which amplifies this converted radio frequency signals, after that, reading out the control voltage from the storage unit in response to a linear control signal, followed by applying this read control voltage to the level variable unit and a control electrode of the amplifier.

According to this method, in the transmission apparatus, it is possible to employ the amplifier similarly to the level variable circuit in that the gain of the amplifier is controlled linearly. Thus, it is possible to delete the level variable circuit of the RF stage that is required for the method up to the present. For that reason, it becomes possible to realize simplification of the circuit configuration, as well as it is possible to cut power consumption corresponding to that of the deleted level variable circuit.

A power control method of the present invention, in the above-described method, performs detection in connection with output voltage of the amplifier, subsequently, followed by adjusting output power quantity of the amplifier by the use of the level variable unit if this detection voltage falls in an output range where the gain of the amplifier is saturated fixedly.

According to this method, in the amplifier of the transmission apparatus, it becomes possible to employ the amplifier as two kinds of circuits in which the amplifier is employed as a level variable circuit in a low level output range, while the amplifier is employed as an amplifier with specific gain in a high level output range.

A power control method of the present invention permits a level to be varied in connection with intermediate frequency signals by the use of a level variable unit, subsequently, converting this intermediate frequency signals with its level varied into radio frequency signals, next, permitting a storage unit to store therein a control voltage at the time of an inverse gain characteristic of an amplifier which amplifies the converted radio frequency signals, then, reading out the control voltage from the storage unit in response to received transmission power control information, followed by applying the read control voltage to the level variable unit and a control electrode of the amplifier.

According to this method, since the control unit of the radio apparatus controls the gain of the amplifier on the basis of the received transmission level control information, it is possible to control the transmission power automatically in response to the control information transmitted from the radio apparatus of the partner side.

A power control method of the present invention, in the above-described method, permits detection to be performed in connection with an output voltage of the amplifier, followed by adjusting output power quantity of the amplifier by the use of the level variable unit if this detection voltage falls in an output range where the gain of the amplifier is saturated fixedly.

According to this method, in the amplifier of the radio apparatus, it becomes possible to employ the amplifier as two kinds of circuits in which the amplifier is employed as a level variable circuit in a low level output range, while the amplifier is employed as an amplifier with specific gain in a high level output range.

As described above, according to the present invention, it is possible to realize miniaturization of a scale of an amplifier, a decrease of power consumption and an improvement of efficiency when an output level is low or at the time a signal is not inputted.

This application is based on the Japanese Patent Application No. HEI 11-119594 filed on April 27, 1999, entire content of which is expressly incorporated by reference herein.

### Industrial Applicability

The present invention is applicable to a base station apparatus and/or a mobile station apparatus and so forth in a digital mobile communication system.

## Claims

1. A power control apparatus comprising:
an amplifier for amplifying signals;
storage means for storing therein a control voltage at the time of an inverse gain characteristic of said amplifier; and
control means for reading out said control voltage from said storage means in response to a linear control signal, followed by applying said read control voltage to a control electrode of said amplifier.

2. A power control apparatus according to claim 1, wherein if the amplifier is a field-effect transistor, said control voltage corresponds to a gate voltage of said field-effect transistor.

3. A power control apparatus according to claim 1, further comprising a detector for performing detection of an output voltage of said amplifier, followed by outputting this detection voltage to said control means, wherein said control means adjusts output power quantity in such a manner as to satisfy a distortion characteristic of said amplifier if said detection voltage falls in a range where gain of said amplifier is saturated fixedly.

4. A transmission apparatus comprising:
level variable means for permitting a level to be varied in connection with an intermediate frequency signal;
a mixer for converting said intermediate frequency signal from said level variable means into a radio frequency signal;
an amplifier for amplifying said radio frequency signal;
storage means for storing therein a control voltage at the time of an inverse gain characteristic of said amplifier; and
control means for reading out said control voltage from said storage means in response to a linear control signal, followed by applying said read control voltage to said level variable means and a control electrode of said amplifier.

5. A transmission apparatus according to claim 4, wherein if the amplifier is a field-effect transistor, said control voltage corresponds to a gate voltage of said field-effect transistor.

6. A transmission apparatus according to claim 4, further comprising a detector for performing detection of an output voltage of said amplifier, followed by outputting this detection voltage to said control means, wherein said transmission apparatus permits operation of said control means to halt in the case where said detection voltage corresponds to such a voltage value that gain of said amplifier is saturated fixedly regardless of control by the use of the control voltage.

7. A radio apparatus provided with a transmission apparatus according to claim 4 and reception means of signals, in which control means of said transmission apparatus reads out a control voltage, instead of a control signal, from storage means of said transmission apparatus in response to transmission power control information received through said reception means, followed by applying this read control voltage to a level variable means and a control electrode of an amplifier of said transmission apparatus.

8. A mobile station apparatus provided with a transmission apparatus according to claim 4 and reception means of signals, in which control means of said transmission apparatus reads out a control voltage, instead of a control signal, from storage means of said transmission apparatus in response to transmission power control information from a base station apparatus received through said reception means, followed by applying this read control voltage to a level variable means and a control electrode of an amplifier of said transmission apparatus.

9. A mobile communication system provided with a base station apparatus transmitting transmission power control information, a transmission apparatus according to claim 4 and reception means of signals, in which control means of said transmission apparatus reads out a control voltage, instead of a control signal, from storage means of said transmission apparatus in response to transmission power control information from a base station apparatus received through said reception means, further said mobile communication system is provided with a mobile station apparatus which applies this read control voltage to a level variable means and a control electrode of an amplifier of said transmission apparatus.

10. A power control method comprising the steps of:
storing a control voltage at the time of an inverse gain characteristic of an amplifier of signals in storage means;
reading out said control voltage from said storage means in response to a linear control signal; and
applying this read control voltage to a control electrode of said amplifier.

11. A power control method according to claim 10, further comprising the steps of:
performing detection of an output voltage of said amplifier; and
halting control for applying said control voltage to said control electrode of said amplifier in the case where said detection voltage corresponds to such a voltage value that gain of said amplifier is saturated fixedly regardless of control by the use of the control voltage.

12. A transmission power control method comprising the steps of:
permitting a level to be varied in connection with an intermediate frequency signal by the use of level variable means;
converting said intermediate frequency signal with its level varied into a radio frequency signal;
storing a control voltage at the time of an inverse gain characteristic of an amplifier which amplifies this converted radio frequency signal in a storage means;
reading out said control voltage from said storage means in response to a linear control signal; and
applying this read control voltage to said level variable means and a control electrode of said amplifier.

13. A transmission power control method according to claim 12, further comprising the steps of:
performing detection of an output voltage of said amplifier; and
adjusting output power quantity of said amplifier by the use of said level variable means in the case where said detection voltage falls in such an output range that gain of said amplifier is saturated fixedly.

14. A radio method comprising the steps of:
permitting a level to be varied in connection with an intermediate frequency signal by the use of level variable means;
converting said intermediate frequency signal with its level varied into a radio frequency signal;
storing a control voltage at the time of an inverse gain characteristic of an amplifier which amplifies this converted radio frequency signal in a storage means;
reading out said control voltage from said storage means in response to received transmission power control information; and
applying this read control voltage to said level variable means and a control electrode of said amplifier.

15. A radio method according to claim 14, further comprising the step of;
adjusting output power quantity of said amplifier by the use of said level variable means in the case where said detection voltage falls in such an output range that gain of said amplifier is saturated fixedly.
